# EUROPEAN PATENT APPLICATION

(11) **EP 4 641 820 A1**
(43) Date of publication of application: **29.10.2025**
(21) Application number: 23905163.4
(22) Date of filing: 07.06.2023
(51) Int. Cl.: H01M 50/569, H01M 10/48, G01R 1/04, G01R 31/382, G01R 31/396

(54) **SAMPLING STRUCTURE, BATTERY AND VEHICLE**

(30) Priority: 19.12.2022 CN 202211634802
(71) Applicant: BYD Company Limited, Shenzhen, Guangdong 518118 (CN)
(72) Inventor: CHEN, Mingwen, Shenzhen, Guangdong 518118 (CN); LIN, Shuishan, Shenzhen, Guangdong 518118 (CN); HUANG, Jian, Shenzhen, Guangdong 518118 (CN); CAO, Dongkui, Shenzhen, Guangdong 518118 (CN)
(74) Representative: Mathys & Squire
(86) International application number: PCT/CN2023/098873
(87) International publication number: WO 2024/130974

(57) **Abstract**

A vehicle is provided. The vehicle has a battery or a sampling structure. The battery has the sampling structure. The sampling structure includes a sampling circuit. A sampling connector is disposed on the sampling circuit on each of two sides of the sampling circuit in a thickness direction, and the sampling connector is configured to connect to a sampling point.

## Description

### CROSS-REFERENCE TO RELATED APPLICATIONS

This application claims priority to Patent Application No. 202211634802.9, filed on December 19, 2022, and entitled "SAMPLING STRUCTURE, BATTERY, AND VEHICLE", which is incorporated herein by reference in its entirety.

### TECHNICAL FIELD

This application relates to the field of battery technologies, and in particular, to a sampling structure and a battery and a vehicle that have the sampling structure.

### BACKGROUND

With increasing popularity of new energy vehicles, the requirements for use of power batteries in the new energy vehicles are becoming increasingly demanding. In batteries of the related technologies, a single-string cell configuration is usually used. The single-string cell configuration has no intermediate sampling points and features a relatively simple sampling structure.

To improve energy density and the contact capability of the battery, a multi-string cell configuration is provided in the related technologies. However, in the multi-string cell configuration, it is difficult to perform signal sampling on the cells. This is unfavorable for the stable use of the battery.

### SUMMARY

An objective of this application is to provide a sampling structure, so that sampling of a battery can be facilitated, a structure of the battery can be simplified, and performance of the battery can be optimized.

Another objective of this application is to provide a battery. The battery includes the sampling structure.

Still another objective of this application is to provide a vehicle. The vehicle includes the sampling structure or the battery.

The sampling structure according to an embodiment of this application includes a sampling circuit. A sampling connector is disposed on the sampling circuit on each of two sides of the sampling circuit in a thickness direction, and the sampling connector is configured to connect to a sampling point.

In the sampling structure according to the embodiment of this application, sampling of the battery can be facilitated, a structure of the battery can be simplified, and performance of the battery can be optimized.

In addition, the sampling structure according to the embodiment of this application may also have the following additional technical features.

Optionally, in a length direction of the sampling circuit, sampling connectors on the two sides of the sampling circuit are located at a same position.

Optionally, the sampling connectors are disposed on opposite side surfaces of the sampling circuit in the thickness direction.

Optionally, the sampling connector is provided with a receptacle, the receptacle has an open end, and the open end is configured to connect to a sampling point of a cell.

Optionally, the sampling connector includes: a main body portion; a clamping hook, where the clamping hook is connected to the main body portion; and a stopper, where the stopper is connected to the main body portion and cooperates with the clamping hook to position the sampling connector on a cell group. The receptacle is provided on the main body portion, and the clamping hook and the stopper are disposed around the receptacle.

Optionally, the receptacle extends through the main body portion in the thickness direction.

Optionally, the clamping hook includes a connection portion and a clamping protrusion, the connection portion is connected to the main body portion and is disposed as a cantilever extending in the thickness direction, the clamping protrusion is disposed at a free end of the connection portion and is located on a side of the connection portion that is away from the main body portion, the stopper is disposed on an outer circumferential surface of the main body portion, and a minimum distance between the clamping protrusion and the sampling circuit is greater than a maximum distance between the stopper and the sampling circuit, so that the clamping hook cooperates with the stopper to position the sampling connector on the cell.

Optionally, the receptacle is configured as a flat hole extending in the thickness direction.

Optionally, a connection plate is further included. The sampling connectors are disposed on two side surfaces of the connection plate, and any surface of the connection plate is connected to the sampling circuit.

A battery according to an embodiment of this application includes: a cell group; and the sampling structure according to the foregoing descriptions. The sampling structure is connected to a side surface of the cell group.

Optionally, a plurality of cell groups are included. The plurality of cell groups include a first cell group and a second cell group, the sampling structure is disposed between the first cell group and the second cell group, and the sampling connectors on the two sides of the sampling circuit are connected to the first cell group and the second cell group respectively.

Optionally, in a width direction of the sampling circuit, the sampling structure is disposed close to two sides of a side surface of the cell group.

Optionally, the cell group includes at least two cells connected in series in the length direction of the sampling circuit, the cell group has a first end and a second end that are opposite to each other, a first sampling point is provided between the cells connected in series, and the sampling circuit redirects the first sampling point to the first end of the cell group.

Optionally, a second sampling point is provided at the first end of the cell group, and the sampling circuit is electrically connected to the second sampling point.

Optionally, a third sampling point is provided at the second end of the cell group, and the sampling circuit is further configured to redirect the third sampling point to the first end of the cell group.

Optionally, the battery further includes: a first insertion member, where the first insertion member is disposed at the first end of the cell group, and is electrically connected to a corresponding sampling circuit; and a collection plate, the collection plate being disposed at the second end of the cell group, a second insertion member being disposed on the collection plate, and the second insertion member being electrically connected to the first insertion member.

A vehicle according to an embodiment of this application includes the battery according to the foregoing descriptions or the sampling structure according to the foregoing descriptions.

In the sampling structure, the battery, and the vehicle according to embodiments of this application, a sampling point in a cell can be connected to a sampling circuit through a sampling connector, and the sampling point can be redirected to another position by using the sampling circuit. This can help enable connection to a sampling plate, and facilitate the sampling of a voltage, a current, and a charging and discharging situation of each cell, so that charging and discharging, usage, or the like of the battery is fully understood, stability of the battery can be effectively maintained, and battery life, stability, and therefore, safety of the vehicle having the battery is improved.

### BRIEF DESCRIPTION OF THE DRAWINGS

FIG. 1 is a diagram of a sampling structure according to an embodiment of this application;
FIG. 2 is a partial diagram of a sampling structure according to an embodiment of this application;
FIG. 3 is a partial diagram of a sampling structure according to an embodiment of this application;
FIG. 4 is a diagram of a sampling structure according to an embodiment of this application;
FIG. 5 is a diagram of another sampling structure according to an embodiment of this application;
FIG. 6 is a diagram of still another sampling structure according to an embodiment of this application;
FIG. 7 is a diagram of still another sampling structure according to an embodiment of this application;
FIG. 8 is a diagram of still another sampling structure according to an embodiment of this application;
FIG. 9 is a diagram of still another sampling structure according to an embodiment of this application;
FIG. 10 is a diagram of cooperation of a plurality of cell groups of a battery according to an embodiment of this application;
FIG. 11 is a partially enlarged view of a region A in FIG. 10;
FIG. 12 is a diagram of a battery according to an embodiment of this application;
FIG. 13 is a partially enlarged view of a region B in FIG. 11;
FIG. 14 is a sectional view of a battery according to an embodiment of this application;
FIG. 15 is a diagram of a second end of a battery according to an embodiment of this application; and
FIG. 16 is a diagram of a first end of a battery according to an embodiment of this application.

Reference numerals: battery 100, sampling structure 10, sampling circuit 11, connection plate 111, sampling connector 12, receptacle 1201, main body portion 121, clamping hook 122, connection portion 1221, clamping protrusion 1222, stopper 123, cell group 20, first cell group 20a, second cell group 20b, first sampling point 201, second sampling point 202, third sampling point 203, housing 21, first housing 21a, second housing 21b, adapter sheet 22, first adapter sheet 22a, second adapter sheet 22b, mounting port 204, first insertion member 311, second insertion member 312, and collection plate 32.

### DESCRIPTION OF EMBODIMENTS

The following describes in detail embodiments of this application, and examples of embodiments are shown in accompanying drawings. Same or similar reference numerals throughout represent same or similar elements or elements having same or similar functions. Embodiments described below with reference to the accompanying drawings are examples, and are intended to be used to explain this application, but should not be construed as a limitation on this application.

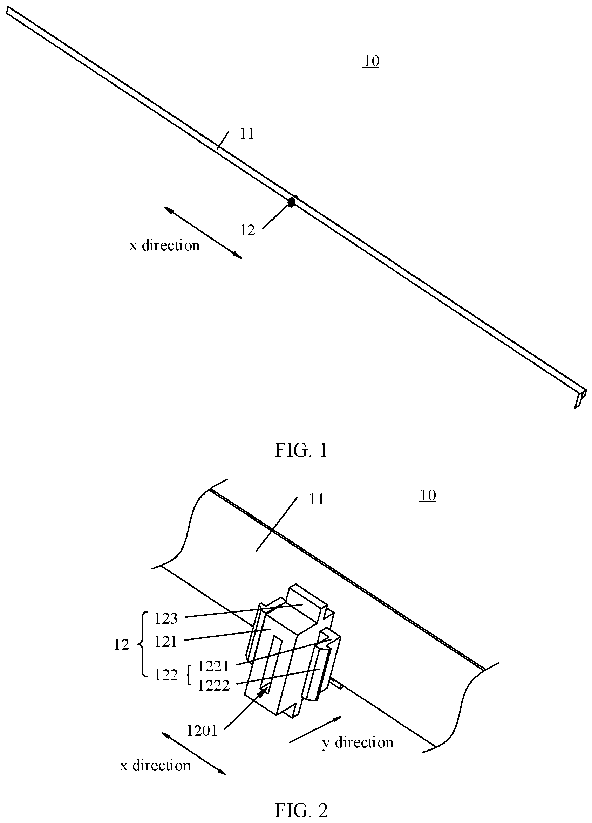

As shown in FIG. 1 to FIG. 3, a sampling structure 10 according to an embodiment of this application includes a sampling circuit 11. The sampling circuit 11 may be configured to: connect to a sampling point in a battery 100 or a cell, and redirect the sampling point to a predetermined position, so that a structure such as a sampling plate is connected to the sampling point, sampling of the battery 100 or the cell is implemented, and an operating status of the battery 100 is understood.

In addition, a sampling connector 12 is disposed on the side of the sampling circuit 11, and the sampling connector 12 is configured to connect to the sampling point, so that the sampling circuit 11 is electrically connected to the sampling point.

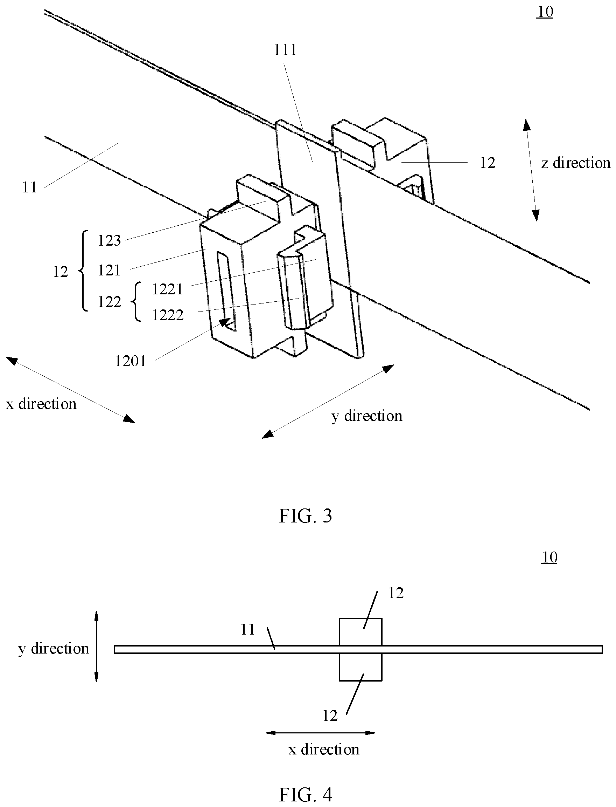

Optionally, as shown in FIG. 3, in a thickness direction of the sampling circuit 11, a sampling connector 12 is disposed on each of two sides of the sampling circuit 11. The sampling connector 12 is disposed on each of the two sides of the sampling circuit 11, so that the sampling circuit 11 can be connected to a plurality of sampling points, to redirect the plurality of sampling points to the predetermined position by using the sampling circuit 11. Therefore, the sampling structure 10 can be simplified, and a structure of the battery 100 can be simplified. In addition, sampling of the battery 100 can be facilitated, an anti-interference capability of a sampling signal can be improved, and accuracy of sampling results is further improved, to facilitate stable control of operation of the battery 100, the cell, or the like.

In the sampling structure 10 according to the embodiment of this application, the plurality of sampling points may be connected to the sampling circuit 11, to redirect the plurality of sampling points to the predetermined position by using the sampling circuit 11, so that the sampling structure 10 can be simplified, a sampling manner of the entire battery 100 can be simplified, and the accuracy of the sampling result can be improved.

Sampling connectors 12 on the two sides of the sampling circuit 11 in the thickness direction (a 'y' direction in the accompanying drawings) in this application may connect sampling points in different cell groups 20. The battery 100 to which this application is applied may include a plurality of cell groups 20. The plurality of cell groups 20 may include a first cell group 20a and a second cell group 20b, and the sampling structure 10 may be disposed between the first cell group 20a and the second cell group 20b. Because the sampling connector 12 is disposed on each of the two sides of the sampling circuit 11 in the thickness direction, the sampling circuit 11 can be connected to the first cell group 20a and the second cell group 20b separately through the sampling connectors 12 on the two sides, and sampling points in the first cell group 20a and the second cell group 20b can be redirected to the predetermined position (for example, an end of the battery 100). Therefore, effective sampling of the battery 100 can be implemented, the sampling structure 10 can be simplified, and sampling efficiency can be improved.

In addition, the sampling connectors 12 on the two sides of the sampling circuit 11 in the thickness direction in this application may alternatively be connected to a plurality of sampling points in a same cell group 20, or may be connected to a same sampling point. That the sampling connectors 12 on the two sides of the sampling circuit 11 are connected to sampling points in different cell groups 20 is mainly described in this application, but does not limit the protection scope of this application.

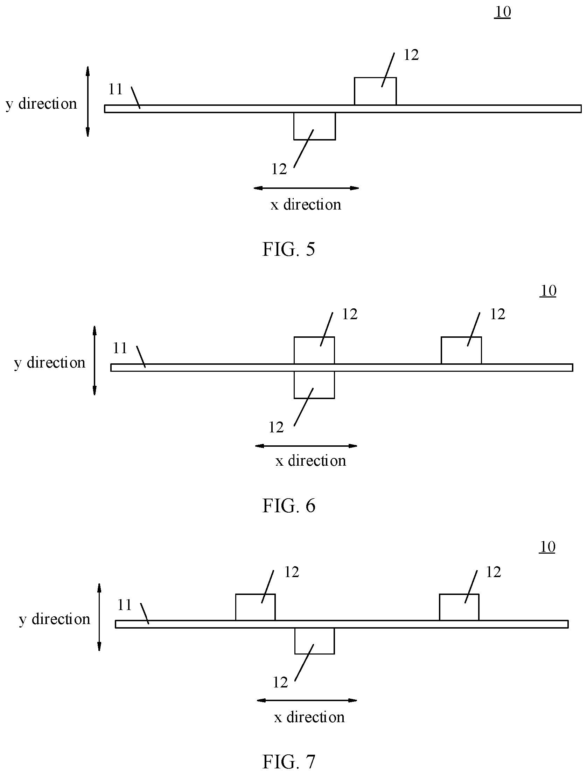

Optionally, each cell group 20 may include a plurality of sampling points. As shown in FIG. 6 and FIG. 7, a plurality of sampling connectors 12 may be disposed on one side of the sampling circuit 11 to connect the plurality of sampling points in the same cell group 20.

In some embodiments of this application, the sampling connectors 12 on the two sides of the sampling circuit 11 in this application may be disposed opposite to each other or disposed in a staggered manner. In other words, the sampling connectors 12 on the two sides of the sampling circuit 11 are or are not disposed opposite to each other in the thickness direction of the sampling circuit 11.

For example, as shown in FIG. 4, one sampling connector 12 is disposed on each of two sides of the sampling circuit 11, and sampling connectors 12 on the two sides of the sampling circuit 11 may be opposite to each other in a thickness direction. As shown in FIG. 5, one sampling connector 12 is disposed on each of two sides of the sampling circuit 11, and sampling connectors 12 on the two sides of the sampling circuit 11 may not be opposite to each other in a thickness direction.

For another example, as shown in FIG. 6, one sampling connector 12 is disposed on one side of the sampling circuit 11, and a plurality of sampling connectors 12 are disposed on the other side. In a thickness direction of the sampling circuit 11, the sampling connector 12 on the side may be opposite to one of the plurality of sampling connectors 12 on the other side. Alternatively, as shown in FIG. 7, in a thickness direction of the sampling circuit 11, one sampling connector 12 on one side may not be opposite to any one of a plurality of sampling connectors 12 on the other side.

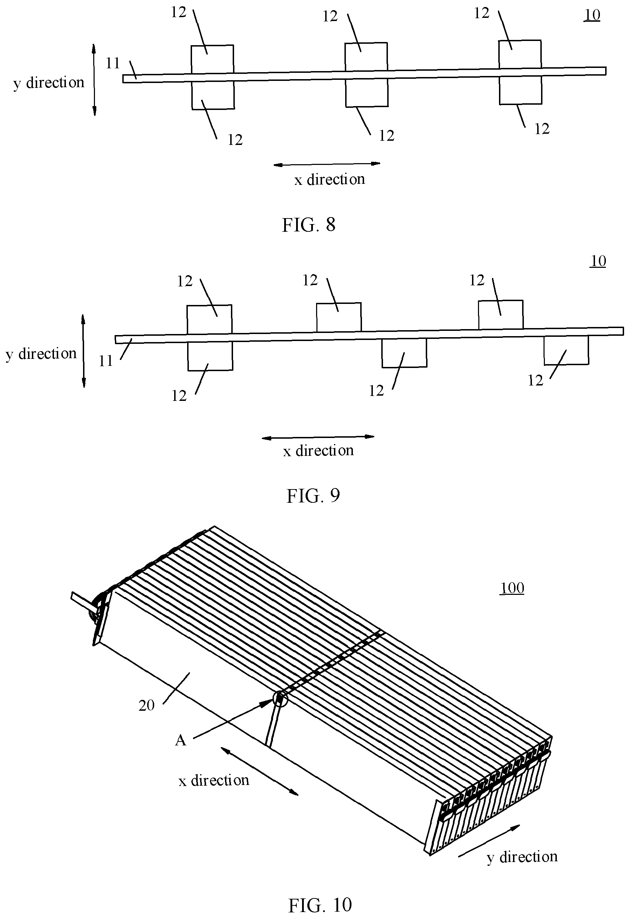

For another example, as shown in FIG. 8, a plurality of sampling connectors 12 are disposed on one side of the sampling circuit 11, and a plurality of sampling connectors 12 are disposed on the other side. In a thickness direction of the sampling circuit 11, the plurality of sampling connectors 12 on the side are opposite to the plurality of sampling connectors 12 on the other side in a one-to-one manner. Alternatively, as shown in FIG. 9, in a thickness direction of the sampling circuit 11, at least one of a plurality of sampling connectors 12 on one side is opposite to at least one of a plurality of sampling connectors 12 on the other side, and another sampling connector 12 among the plurality of sampling connectors 12 on the side is not opposite to the plurality of sampling connectors 12 on the other side. Alternatively, in a thickness direction of the sampling circuit 11, any one of a plurality of sampling connectors 12 on one side is not opposite to a plurality of sampling connectors 12 on the other side.

It should be further noted that quantities of sampling connectors 12 on the two sides of the sampling circuit 11 in the thickness direction may be the same or different.

As shown in FIG. 3 and FIG. 4, in some embodiments of this application, in a length direction of the sampling circuit 11 (an 'x' direction in the accompanying drawings), the sampling connectors 12 on the two sides of the sampling circuit 11 are located at a same position. In this way, the sampling connectors on the two sides of the sampling circuit 11 can be connected to approximately same positions in adjacent cell groups 20. This helps allow access to sampling points at the corresponding positions.

In addition, the sampling connectors 12 on the two sides of the sampling circuit 11 may alternatively be disposed opposite to each other in the thickness direction of the sampling circuit 11. In this way, this can help the sampling circuit 11 to be connected to the cell group 20, to allow access to a sampling point in the cell group 20. Moreover, in a mounting process of the sampling structure 10, a plurality of mounting positions of the sampling circuit 11 may all implement stable mounting of the cell group 20, so that an error-proofing function can be implemented, to facilitate mounting of the sampling circuit 11 and improve stability of the battery 100.

In addition, in some embodiments of this application, the sampling connectors 12 may be disposed on opposite side surfaces of the sampling circuit 11 in the thickness direction. The sampling connectors 12 and the sampling circuit 11 are assembled, so that the sampling structure 10 can be used as a whole. This facilitates mounting of the sampling connectors 12 and helps allow access to the sampling point of the cell. Therefore, the stability of the battery 100 having the sampling structure 10 can be improved, and quick assembly of the battery 100 is facilitated.

As shown in FIG. 2 and FIG. 3, in some embodiments of this application, the sampling connector 12 is provided with a receptacle 1201, the receptacle 1201 has an open end, and the open end is configured to connect to a sampling point of a cell. During use, the sampling point of the cell may be allowed access to through an adapter sheet 22, and the adapter sheet 22 may be inserted into the receptacle 1201, to connect the sampling point to the sampling circuit 11, so that the sampling point can be redirected to the predetermined position by using the sampling circuit 11, and stability of the sampling structure 10 can be improved.

A shape of the receptacle 1201 may be set based on a shape of the adapter sheet 22. The receptacle 1201 may be disposed in a circular shape, an elliptical shape, a triangular shape, a polygonal shape, an irregular shape, or the like, and may be selected based on actual usage. Preferably, the receptacle 1201 may be disposed in a flat-hole shape, to facilitate insertion of the adapter sheet 22 and implement stable cooperation between the adapter sheet 22 and the sampling connector 12, so that quick and stable connection between the adapter sheet 22 and the sampling connector 12 is improved, and stability of cooperation between the sampling connector 12 and the cell is improved.

As shown in FIG. 2 and FIG. 3, the sampling connector 12 may include a main body portion 121, the receptacle 1201 may be disposed on the main body portion 121, and the main body portion 121 may be disposed on the side surface of the sampling circuit 11 in the thickness direction. The main body portion 121 may be mounted on the cell, to implement stable connection between the sampling structure 10 and the cell.

To implement stable connection between the sampling connector 12 and the cell, as shown in FIG. 2 and FIG. 3, the sampling connector 12 according to this application may include a clamping hook 122, and the clamping hook 122 is connected to the main body portion 121. The clamping hook 122 may be connected to the cell through a snap-fit. For example, the clamping hook 122 may extend into an inner side of a housing 21 of the cell, and cooperate with the housing 21 of the cell through the snap-fit.

In addition, to further improve stability of connection between the sampling connector 12 and the cell, as shown in FIG. 2 and FIG. 3, the sampling connector 12 according to this application may further include a stopper 123. When the sampling connector 12 is mounted on the housing 21 of the cell, the stopper 123 may be stopped on an outer side of the housing 21 of the cell. Through cooperation between the clamping hook 122 and the stopper 123, stable connection between the sampling connector 12 and the cell is implemented. The stopper 123 is connected to the main body portion 121 and cooperates with the clamping hook 122, to position the sampling connector 12 on the cell group 20.

Optionally, the receptacle 1201 is provided on the main body portion 121, and the clamping hook 122 and the stopper 123 are disposed around the receptacle 1201. In this way, during assembly, the main body portion 121 may be inserted into the housing 21 of the cell, the receptacle 1201 may be correspondingly inserted into the adapter sheet 22 in the cell group 20, and the sampling connector 12 is stably connected to the cell group 20 through cooperation between the clamping hook 122 and the stopper 123, so that the sampling connector 12 can be quickly and stably connected to the cell, mechanical and automatic mounting can be facilitated, and assembly efficiency of the sampling connector 12 can be improved.

In some embodiments of this application, the receptacle 1201 extends through the main body portion 121 in the thickness direction. In other words, in the thickness direction of the sampling circuit 11, the receptacle 1201 is disposed penetrating the main body portion 121, so that the main body portion 121 can be quickly and stably connected to the adapter sheet 22 (connected to the sampling point), and electrical connection stability between the adapter sheet 22 and the sampling circuit 11 can be improved.

In addition, as shown in FIG. 2 and FIG. 3, to facilitate mounting of the sampling connector 12, the clamping hook 122 may be disposed in an elastic cantilever shape. In this way, during mounting of the sampling connector 12, the clamping hook 122 can quickly cooperate with the housing 21 of the cell through the snap-fit by using an elastic deformation capability of the clamping hook 122. Specifically, the clamping hook 122 includes a connection portion 1221 and a clamping protrusion 1222. The connection portion 1221 is connected to the main body portion 121 and is disposed as a cantilever extending in the thickness direction. The clamping protrusion 1222 is disposed at a free end of the connection portion 1221 and is located on a side of the connection portion 1221 that is away from the main body portion 121. The stopper 123 is disposed on an outer circumferential surface of the main body portion 121. A minimum distance between the clamping protrusion 1222 and the sampling circuit 11 is s1, a maximum distance between the stopper 123 and the sampling circuit 11 is s2, and s1 is greater than s2, so that the clamping hook 122 cooperates with the stopper 123 to position the sampling connector 12 on the cell. During assembly, an elastic deformation capability of the connection portion 1221 can enable the clamping protrusion 1222 to move toward the main body portion 121, to reduce a radial size of the sampling connector 12, so that the clamping hook 122 can smoothly extend into the housing 21 of the cell. Under an elastic reset action of the clamping hook 122, the clamping protrusion 1222 can hook onto an inner side surface of the housing 21 of the cell. In this case, the stopper 123 is stopped on an outer side surface of the housing 21. Therefore, the sampling connector 12 can be quickly and stably connected to the housing 21 of the cell through cooperation between the clamping hook 122 and the stopper 123.

As shown in FIG. 3, two opposite sides of the main body portion 121 each are connected to a clamping hook 122, and a stopper 123 is disposed on each of two other opposite sides of the main body portion 121. In other words, two clamping hooks 122 and two stoppers 123 are alternately spaced apart in a circumferential direction of the main body portion 121 and are arranged in a basically even manner. Therefore, connection strength between the sampling connector and the housing 21 of the cell can be improved. In addition, the clamping hooks 122 are disposed on the two opposite sides of the main body portion 121. Therefore, after the sampling connector 12 is fastened to the housing 21 of the cell, the clamping hooks 122 can be disengaged from the housing 21 of the cell by applying opposite force on the clamping hooks 122 on the two opposite sides of the main body portion 121, to detach the sampling connector 12 from the housing 21 of the cell.

With reference to the foregoing descriptions, as shown in FIG. 2 and FIG. 3, the receptacle 1201 is configured as a flat hole extending in the thickness direction. When the sampling connector 12 and the housing 21 of the cell are assembled, can be quickly and stably connected to the adapter sheet 22. In addition, space utilization of the battery 100 can be improved.

As shown in FIG. 3, in some embodiments of this application, a connection plate 111 is further included. The sampling connectors 12 are disposed on two side surfaces of the connection plate 111, and any surface of the connection plate 111 is connected to the sampling circuit 11. The connection plate 111 is disposed, so that connection stability between the sampling connector 12 and the sampling circuit 11 can be improved. Therefore, the sampling connector 12 can be stably connected to the sampling circuit 11, and the sampling circuit 11 is stably electrically connected to the sampling point.

In the sampling structure 10 according to the embodiment of this application, the sampling connectors 12 are disposed on the two sides of the sampling circuit 11 in the thickness direction. The sampling structure 10 can be stably connected to the sampling point in the cell group 20 through the sampling connector 12, to simplify structure of the battery 100 and improve the sampling efficiency and sampling accuracy. In addition, this application further provides a battery 100. The battery 100 may include the foregoing sampling structure 10. The following describes the battery 100 according to the embodiment of this application with reference to the accompanying drawings.

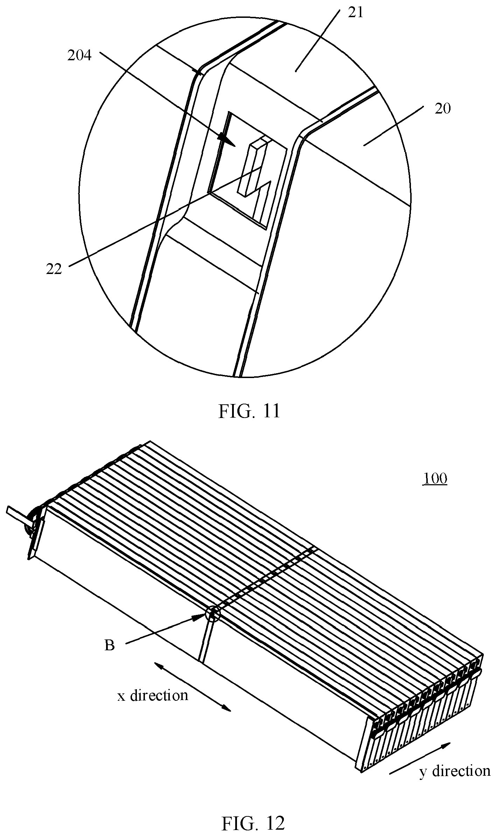

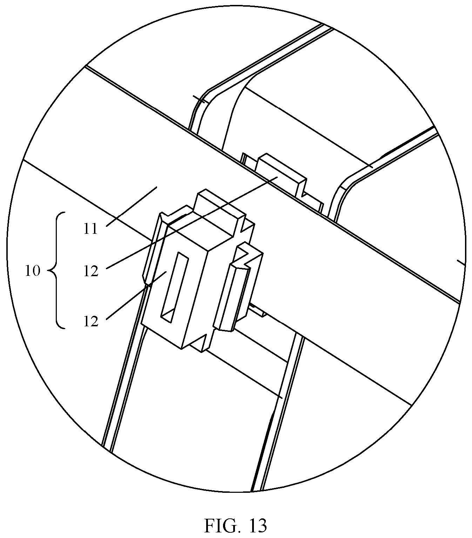

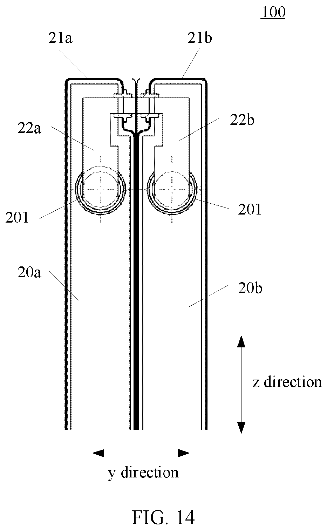

As shown in FIG. 10 to FIG. 16, the battery 100 according to an embodiment of this application includes: a cell group 20; and the sampling structure 10 according to the foregoing descriptions. The foregoing sampling structure 10 is disposed, so that the sampling structure 10 can be stably connected to the cell group 20. This helps allow access to a sampling point in the cell group 20, to implement sampling of the sampling point. Therefore, a control module of the battery 100 can leam about a working status of the battery 100 in a timely manner, to adjust a battery level, a voltage, heat, and the like of the cell group 20 based on the working status of the battery 100, so that the battery 100 can operate stably, and a battery life and stability of the battery 100 are improved.

In addition, in this application, the sampling structure 10 is connected to a side surface of the cell group 20, so that an increase in a size of the cell group 20 in a width direction can be avoided, space of the cell group 20 can be fully utilized, space utilization can be improved, and therefore, energy density of the battery 100 can be improved. Moreover, the sampling structure 10 is disposed on the side surface of the cell group 20, so that can be connected to adjacent cell groups 20 through sampling connectors 12 on two sides of a sampling circuit 11 in a thickness direction respectively. Therefore, the sampling structure 10 of the cell group 20 can be simplified, and stability of the battery 100 can be improved.

It should be further noted that, during mounting of the battery 100, a margin for expansion is usually reserved. Therefore, in this application, the sampling structure 10 is disposed on the side surface of the cell group 20 without affecting space for the battery 100. Specifically, a thickness direction of a cell (or the thickness direction of the sampling circuit 11) is set as a 'y' direction, a length direction of the cell (or an extension direction of the sampling circuit 11) is set as an 'x' direction, and a width direction of the cell (or a width direction of the sampling circuit 11) is set as a 'z' direction. In this application, the sampling structure 10 is disposed on the side surface of the cell group 20, so that space in the z direction can be reduced, an increase in a size of the battery 100 caused by the sampling structure 10 being placed at an end of the cell in the z direction can be avoided. In addition, space in the y direction is also not affected (the cell may expand in the y direction during use, and therefore, specific space for expansion may be reserved in the y direction when the cell is manufactured; and expansion usually occurs at the middle of the battery 100, and therefore, the space in the y direction is not affected when is disposed on a side edge), and costs are reduced.

With reference to FIG. 10 to FIG. 13, a mounting port 204 is provided on the side surface of the cell group 20, an adapter sheet 22 is disposed in the cell group 20, one end is connected to a first sampling point 201, and the other end is opposite to the mounting port 204. The sampling connector 12 is inserted into and positioned in the mounting port 204, and the adapter sheet 22 is inserted into an interface on a sampling machine head correspondingly.

As shown in FIG. 10 to FIG. 15, in some embodiments of this application, a plurality of cell groups 20 are included, the plurality of cell groups 20 include a first cell group 20a and a second cell group 20b, the sampling structure 10 is disposed between the first cell group 20a and the second cell group 20b, and the sampling connectors 12 on the two sides of the sampling circuit 11 are connected to the first cell group 20a and the second cell group 20b respectively. Sampling points in the first cell group 20a and the second cell group 20b can be allowed access to by using the sampling circuit 11, so that a structure of allowing access to the sampling points of the first cell group 20a and the second cell group 20b can be simplified. This helps allow access to the sampling point to a predetermined position, to connect to the sampling plate.

The first cell group 20a may include one or more sampling points, a sampling connector 12 is correspondingly disposed at at least a part of the sampling points, and the sampling point is redirected to the predetermined position. Similarly, the second cell group 20b may also include one or more sampling points, a sampling connector 12 is correspondingly disposed at at least a part of the sampling points, and sampling points in different cell groups 20 are redirected to predetermined positions by using one sampling circuit 11.

In addition, the battery 100 may include a plurality of first cell groups 20a and a plurality of second cell groups 20b, the plurality of first cell groups 20a and the plurality of second cell groups 20b may be alternately arranged in the thickness direction, and the sampling structure 10 is disposed between the first cell group 20a and the second cell group 20b that are adjacent to each other.

It should be further noted that the battery 100 may have a plurality of sampling manners. For example, the battery 100 in this application may include the first cell group 20a and the second cell group 20b, and may also include a third cell group. Sampling is provided between the first cell group 20a and the second cell group 20b by using the foregoing sampling structure 10 in this application, and the third cell group may be sampled in another type of sampling manner.

In some embodiments of this application, in the width direction of the sampling circuit 11, the sampling structure 10 is disposed close to two sides of a side surface of the cell group 20. The battery 100 may expand during use. Generally, in the width direction of the sampling circuit 11, large expansion occurs in the middle of the cell, and small expansion occurs on a side edge. The sampling circuit 11 is disposed close to a side edge of the cell group 20, so that the sampling circuit 11 can be prevented from affecting space for expansion of the cell group 20, and large space for expansion can be reserved for the cell group 20, to help the battery 100 operate stably.

As shown in FIG. 10 to FIG. 14, in some embodiments of this application, the cell group 20 includes at least two cells connected in series in the length direction of the sampling circuit 11. A plurality of cell groups 20 may form a large group of batteries 100 or a large pack of batteries 100, to meet requirements such as a working voltage.

The cell group 20 has a first end and a second end that are opposite to each other, a first sampling point 201 is provided between the cells connected in series, and the sampling circuit 11 redirects the first sampling point 201 to the first end of the cell group 20. When the cell group 20 includes two cells connected in series, there may be one first sampling point 201 between the two cell groups 20. When the cell group 20 includes more than three cells connected in series, there may be one first sampling point 201 between every two cell groups 20, and different first sampling points 201 may be allowed access to by using a same sampling structure 10 or different sampling structures 10.

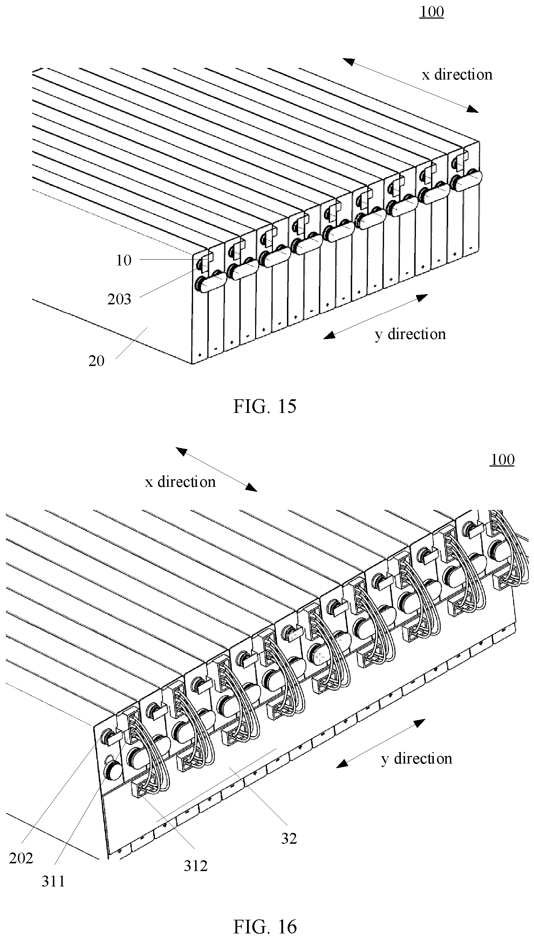

In addition, there may be a sampling point at the first end and the second end of the cell group 20. As shown in FIG. 15, a second sampling point 202 is provided at the first end of the cell group 20, and the sampling circuit 11 is electrically connected to the second sampling point 202. In addition, as shown in FIG. 16, a third sampling point 203 is provided at the second end of the cell group 20, and the sampling circuit 11 is further configured to redirect the third sampling point 203 to the first end of the cell group 20. Therefore, sampling points at different positions in the cell group 20 can be allowed access to at a same end of the cell group 20 by using the sampling circuit 11, so that the sampling plate can be connected to different sampling points in the cell group 20, centralized sampling of the cell group 20 is facilitated, to help detect an operating status of the cell group 20, optimize detection efficiency of the battery 100, find a problem during operation of the cell group 20 in a timely manner, and improve stability of the cell group 20 and the battery 100 during operation.

In addition, the cell in this application may include two, three, or more electrodes.

An example in which a first electrode and a second electrode are provided at each of two ends of the cell is used. Specifically, a first electrode of one cell is configured as the third sampling point 203. A second electrode of the cell is connected to a first electrode of another cell, to be configured as the first sampling point 201. A second electrode of another cell is configured as the second sampling point 202. The first sampling point 201, the second sampling point 202, and the third sampling point 203 may be redirected to a same end of the cell group 20 by using the sampling structure 10, to help connect to a sampling group. Further, the first cell group 20a and the second cell group 20b may have a same structure, and a first sampling point 201 of the first cell group 20a and a first sampling point 201 of the second cell group 20b may be connected to the sampling circuit 11 through the sampling connectors 12 on the two sides of the sampling circuit 11 in the thickness direction. In addition, a third sampling point 203 of the first cell group 20a and a third sampling point 203 of the second cell group 20b may also be connected to the sampling circuit 11 through the sampling connectors 12 on the two sides of the sampling circuit 11 in the thickness direction.

In addition, two poles may also be disposed at a high potential in the cell of this application, one for overcurrent and the other for sampling. The two poles of high potential may be disposed at a same end or at two different ends of the cell. The sampling circuit 11 in this application may be of an FPC (flexible printed circuit) structure. The sampling connector 12 may be integrated through injection molding, to improve structural strength and insulation performance.

In addition, in this application, cells in different cell groups 20 or a plurality of cells in a same cell group 20 may be of a same chemical system, for example, may be all secondary batteries such as lithium iron phosphate batteries, ternary lithium batteries, and sodium batteries, or may be of mixing of different chemical systems and used in pairs. In this case, material mixing should not be performed during assembly.

In addition, it should be further noted that the end of the sampling circuit 11 of this application may be soldered to the second sampling point 202.

In a specific example of this application, the first cell group 20a may include a first housing 21a, and the second cell group 20b may include a second housing 21b. The first housing 21a is provided with a first mounting port, and the second housing 21b is provided with a second mounting port. The first mounting port and the second mounting port are opposite to each other in a Y direction, the sampling circuit 11 is disposed between the first mounting port and the second mounting port, and the sampling connectors 12 on the two sides of the sampling circuit 11 are respectively fastened to the first mounting port and the second mounting port in a clamping manner. A first adapter sheet 22a is disposed in the first cell group 20a, and a second adapter sheet 22b is disposed in the second cell group 20b. The first adapter sheet 22a is electrically connected to a positive electrode, a negative electrode, or a composite electrode in the first cell group 20a, the second adapter sheet 22b is electrically connected to a positive electrode, a negative electrode, or a composite electrode in the second cell group 20b, and the first adapter sheet 22a and the second adapter sheet 22b are respectively inserted into receptacles 1201 of corresponding sampling connectors 12.

As shown in FIG. 16, in some embodiments of this application, the battery 100 further includes a first insertion member 311. The first insertion member 311 is disposed at the first end of the cell group 20, and is electrically connected to a corresponding sampling circuit 11. The first insertion member 311 may be electrically connected to the sampling circuit 11, to provide an interface for the sampling circuit 11. This helps the sampling circuit 11 be connected to a collection plate 32.

The battery 100 of this application may further include a collection plate 32. The collection plate 32 is disposed at the second end of the cell group 20, a second insertion member 312 is disposed on the collection plate 32, and the second insertion member 312 is electrically connected to the first insertion member 311. The second insertion member 312 cooperates with the first insertion member 311, so that the collection plate 32 can be stably electrically connected to the sampling circuit 11, assembly efficiency of the battery 100 can be improved, and sampling accuracy can be optimized.

A vehicle according to an embodiment of this application includes the battery 100 according to the foregoing descriptions or the sampling structure 10 according to the foregoing descriptions. The foregoing battery 100 and sampling structure 10 are used, so that a sampling point in a cell can be connected to a sampling circuit 11 through a sampling connector 12, and the sampling point can be redirected to another position by using the sampling circuit 11. This can help connect to a sampling plate, and facilitate sampling of a voltage, a current, and a charging and discharging situation of each cell, so that charging and discharging, usage, or the like of the battery 100 is fully understood, stability of the battery 100 can be effectively maintained, and a battery life, stability, and therefore, safety of the vehicle having the battery 100 is improved.

In addition, the terms "first" and "second" are merely intended for a purpose of description, and shall not be understood as an indication or implication of relative importance or implicit indication of a quantity of indicated technical features. Therefore, a feature limited by "first" or "second" may explicitly or implicitly include at least one of the features. In the descriptions of this application, unless otherwise specifically limited, "a plurality of" means at least two, for example, two or three.

In this application, unless otherwise specified and limited, terms "mount", "link", "connect", "fasten", and the like should be understood in a broad sense. For example, the term may indicate a fixed connection, a detachable connection, or an integrated connection, may indicate a mechanical connection or an electrical connection, or may indicate a direct connection, an indirect connection through an intermediate medium, internal communication between two elements, or an interaction relationship between two elements, unless otherwise specified. A person of ordinary skill in the art may understand specific meanings of the foregoing terms in this application based on specific situations.

In this application, unless otherwise specified and limited, when a first feature is "above" or "below" a second feature, the first feature may be in direct contact with the second feature, or the first feature may be in indirect contact with the second feature through an intermediate medium. In addition, that the first feature is "on", "above", or "over" the second feature may be that the first feature is right above or obliquely above the second feature, or may merely mean that a horizontal height of the first feature is greater than that of the second feature. That the first feature is "below" or "under" the second feature may be that the first feature is right below or obliquely below the second feature, or may merely mean that a horizontal height of the first feature is less than that of the second feature.

In the descriptions of this specification, the reference term "an embodiment", "some embodiments", "example", "specific example", "some examples", or the like means that the specific features, structures, materials, or characteristics described with reference to the embodiment or example are included in at least one embodiment or example of this application. In this specification, the illustrative expressions of the foregoing terms are not necessarily directed to the same embodiment or example. In addition, the described specific features, structures, materials, or characteristics may be combined in an appropriate manner in any one or more of embodiments or examples. Moreover, a person skilled in the art may combine and associate different embodiments or examples and features of different embodiments or examples described in this specification without mutual contradiction.

Although embodiments of this application have been shown and described above, it may be understood that the foregoing embodiments are examples and should not be understood as a limitation on this application, and changes, modifications, replacement, and variations may be made to the foregoing embodiments by a person of ordinary skill in the art within the scope of this application.

## Claims

1. A sampling structure (10), comprising a sampling circuit (11), wherein a sampling connector (12) is disposed on the sampling circuit (11) on each of two sides of the sampling circuit (11) in a thickness direction of the sampling circuit (11), and the sampling connector (12) is configured to connect to a sampling point.

2. The sampling structure (10) according to claim 1, wherein in a length direction of the sampling circuit (11), sampling connectors (12) on the two sides of the sampling circuit (11) are located at a same position.

3. The sampling structure (10) according to claim 1 or 2, wherein the sampling connectors (12) are disposed on opposite side surfaces of the sampling circuit (11) in the thickness direction.

4. The sampling structure (10) according to any one of claims 1 to 3, wherein the sampling connector (12) is provided with a receptacle (1201), the receptacle (1201) has an open end, and the open end is configured to connect to a sampling point of a cell.

5. The sampling structure (10) according to claim 4, wherein the sampling connector (12) comprises:
a main body portion (121);
a clamping hook (122), wherein the clamping hook (122) is connected to the main body portion (121); and
a stopper (123), wherein the stopper (123) is connected to the main body portion (121) and cooperates with the clamping hook (122) to position the sampling connector (12) on a cell group (20), wherein
the receptacle (1201) is provided on the main body portion (121), and the clamping hook (122) and the stopper (123) are disposed around the receptacle (1201).

6. The sampling structure (10) according to claim 5, wherein the receptacle (1201) extends through the main body portion (121) in the thickness direction.

7. The sampling structure (10) according to claim 6, wherein the clamping hook (122) comprises a connection portion (1221) and a clamping protrusion (1222), the connection portion (1221) is connected to the main body portion (121) and is disposed as a cantilever extending in the thickness direction, the clamping protrusion (1222) is disposed at a free end of the connection portion (1221) and is located on a side of the connection portion (1221) that is away from the main body portion (121), the stopper (123) is disposed on an outer circumferential surface of the main body portion (121), and a minimum distance between the clamping protrusion (1222) and the sampling circuit (11) is greater than a maximum distance between the stopper (123) and the sampling circuit (11), so that the clamping hook (122) cooperates with the stopper (123) to position the sampling connector (12) on the cell.

8. The sampling structure (10) according to any one of claims 5 to 7, wherein the receptacle (1201) is configured as a flat hole extending in the thickness direction.

9. The sampling structure (10) according to any one of claims 1 to 8, further comprising a connection plate (111), wherein the sampling connectors (12) are disposed on two side surfaces of the connection plate (111), and any surface of the connection plate (111) is connected to the sampling circuit (11).

10. A battery (100), comprising:
a cell group (20); and
the sampling structure (10) according to any one of claims 1 to 9, wherein the sampling structure (10) is connected to a side surface of the cell group (20).

11. The battery (100) according to claim 10, wherein a plurality of cell groups (20) are comprised, the plurality of cell groups (20) comprise a first cell group (20a) and a second cell group (20b), the sampling structure (10) is disposed between the first cell group (20a) and the second cell group (20b), and the sampling connectors (12) on the two sides of the sampling circuit (11) are connected to the first cell group (20a) and the second cell group (20b) respectively.

12. The battery (100) according to claim 10 or 11, wherein in a width direction of the sampling circuit (11), the sampling structure (10) is disposed close to two sides of a side surface of the cell group (20).

13. The battery (100) according to claim 10, wherein the cell group (20) comprises at least two cells connected in series in the length direction of the sampling circuit (11), the cell group (20) has a first end and a second end that are opposite to each other, a first sampling point (201) is provided between the cells connected in series, and the sampling circuit (11) redirects the first sampling point (201) to the first end of the cell group (20).

14. The battery (100) according to claim 13, wherein a second sampling point (202) is provided at the first end of the cell group (20), and the sampling circuit (11) is electrically connected to the second sampling point (202); and/or
a third sampling point (203) is provided at the second end of the cell group (20), and the sampling circuit (11) is further configured to redirect the third sampling point (203) to the first end of the cell group (20).

15. The battery (100) according to claim 13 or 14, wherein the battery (100) further comprises:
a first insertion member (311), wherein the first insertion member (311) is disposed at the first end of the cell group (20), and is electrically connected to a corresponding sampling circuit (11); and
a collection plate (32), the collection plate (32) is disposed at the second end of the cell group (20), a second insertion member (312) is disposed on the collection plate (32), and the second insertion member (312) is electrically connected to the first insertion member (311).

16. A vehicle, comprising the battery (100) according to any one of claims 10 to 15 or the sampling structure (10) according to any one of claims 1 to 9.
